# EUROPÄISCHE PATENTSCHRIFT

(11) **EP 0 207 005 B1**
(45) Veröffentlichungstag und Bekanntmachung des Hinweises auf die Patenterteilung: **16.02.1994**
(21) Anmeldenummer: 86810289.8
(22) Anmeldetag: 25.06.1986
(51) Int. Cl.: H05K 9/00

(54) **Dichtung an gehäuseartigen Einrichtungen mit elektrischen Geräten**
Sealing of a casing-like device containing electrical appliances
Etanchéité pour boîtier contenant un appareil électrique

(30) Priorität: 28.06.1985 CH 2748/85
(43) Veröffentlichungstag der Anmeldung: 30.12.1986
(73) Patentinhaber: Senn, Jakob, CH-6648 Minusio (CH)
(72) Erfinder: Senn, Jakob, CH-6648 Minusio (CH)
(74) Vertreter: Schaumburg, Thoenes & Thurn

(56) Entgegenhaltungen:
- FR-A- 2 308 030
- FR-A- 2 509 949
- IBM TECHNICAL DISCLOSURE BULLETIN, Band 20, Nr. 3, August 1977, Seite 1091, New York, US; E.G. CROSBY et al.: "Plastic with conductive and magnetic particles for electromagnetic shielding"
- IBM TECHNICAL DISCLOSURE BULLETIN, Band 23, Nr. 2, Juli 1980, Seiten 698-699, New York, US; R.C. CHU et al.: "Multi-functional interior cover system for high performance electronic equipment"

## Beschreibung

Gegenstand der vorliegenden Erfindung ist eine Dichtung an gehäuseartigen Einrichtungen nach dem Oberbegriff des Patentanspruches 1.

Dichtungen aus gummielastischem Material, um den Zugang von Gasen, Flüssigkeiten und Fremdstoffen durch Fingen und Zwischenräumen bei einander anliegenden Bauteilen, wie Türen, Schieber und Fenster zu vermeiden, sind in verschiedenen Ausführungen bekannt, welche ihren Zweck im allgemeinen mit Zufriedenheit erfüllen, wenn in deren Bereich sich keine elektrischen Geräte befinden. Es sind auch Systeme bekannt, welche zugleich die Abschirmung von elektrischen und magnetischen Feldern veranlassen, wie aus den beiden nachfolgend genannten Vorpublikationen hervorgeht.

Die FR-A-2 308 030 zeigt einen deformierbaren, elastischen, fugendichtenden und isolierenden Verbindungskörper zwischen zwei Metallstücken mit Faradaykäfig-Effekt zur Erhaltung der elektrischen Kontinuität. Der Verbindungskörper ist großräumig, hat eine Metallnetz-Umhüllung, welche einem Gewebeteil aufliegt.

Die FR-A-2 509 949 zeigt eine Abschirmung mit zwei im Abstand nebeneinander befindlichen Bändern, welche tangential bzw. punktartig an einem stromleitenden Rundkörper festgeklebt sind und ein offenes raumbeanspruchendes Profil mit beidseitig abstehenden Teilen sowie relativ tiefen, spitzwinkeligen Fingen formieren.

Der Erfindung liegt die Aufgabe zugrunde eine leicht und rationell herstellbare Dichtung zu schaffen, welche durch äußere Einwirkungen wie Schläge, Verzehrungen und Temperatureinflüsse dank kompakter, geschlossener Ausbildung sich nicht leicht beschädigen läßt und die Mängel bekannter Ausführungen beseitigt.

Diese Aufgabe wird gelöst mit den Merkmalen des kennzeichnenden Teiles des Patentanspruches 1. Weitere vorteilhafte Ausbildungen der Dichtung sind den abhängigen Patentansprüchen 2 bis 6 entnehmbar.

Nachfolgend ist die Erfindung an Ausführungsbeispielen anhand der Zeichnungen erläutert, und zwar zeigen:
- Fig.1: einen Vertikalschnitt der Dichtung in einer Nut mit Zwei einander flach anliegenden Bauteilen in einem ersten Ausführungsbeispiel,
- Fig. 2: die Dichtung allein im Vertikalschnitt in größerem Maßstab,
- Fig. 3: einen Vertikalschnitt des Abdichtungskörpers in einem zweiten Ausführungsbeispiel,
- Fig. 4: einen ebensolchen Vertikalschnitt in einem dritten Ausführungsbeispiel,
- Fig. 5: einen weiteren Vertikalschnitt in einem vierten Ausführungsbeispiel.

1 bezeichnet einen Bauteil, ein Gehäuse oder eine Tischplatte einer elektrischen Steuerungsvorrichtung. Der Bauteil 1 besitzt eine herkömmliche Nut 2, in welcher der Abdichtungskörper 3 eingebracht ist. Dem Bauteil 1 und dem Abdichtungskörper 3 liegt der Bauteil 4 auf. Der Bauteil 4 ist beispielsweise die Tischplatte eines Kommandogerätes oder die Gehäusewand eines Computers. Der Abdichtungskörper 3 ist durch ein langgestrecktes Profil 5 aus elastischem Werkstoff, wie Schaumkunststoff mit offenen oder geschlossenen Poren gebildet. 6 bezeichnet ein im Inneren des Profiles 5 befindliches, hohlkörperartiges, letzteres quer durchsetzendes Abschirmelement, welches eine bandförmige Seele 7 aus elastischem Material, wie Schaumkunststoff oder dergleichen enthält, die mit einer foliendünnen Umhüllung 8 aus stromleitendem Werkstoff eingefasst ist. Die Umhüllung 8 ist innenseitig mit der Oberfläche der Seele 7 durch einen organischen oder anorganischen Klebstoff kraftschlüssig und eine dauerhafte Oberflächenverbindung vereinigt. Die einander gegenüberliegenden Höhenseiten der Umhüllung 8 sind mit den Profilteilen 5' verklebt. Das Elastizitätsmodul des Werkstoffes der Seele 7 und des durch die Profilteile 5' gebildeten Profiles 5 ist so gewählt, daß der Werkstoff der Profilteile 5' weichelastisch und derjenige der Seele 7 zähelastisch ist. Die Grösse des Abdichtungskörpers 3 richtet sich nach der Ausbildung der Einrichtung; sind in diese ein oder mehrere elektrische Geräte mit höheren Frequenzen oder elektromagnetischen Schwingungen eingebaut, ist eine Breite von ca. 8-12 mm und eine Höhe von ca. 10-14 mm geeignet.

Ist der Abdichtungskörper 3 der Feuchtigkeit ausgesetzt, sei es durch Gase oder flüssige Medien, so ist für die Profilteile 5' ein Schaumkunststoff mit geschlossenen Poren vorteilhaft. Bei Beschädigungsgefahr der Oberfläche des Profiles 5 durch physische oder chemische Vorgänge ist das Ankleben oder Anbringen einer geeigneten Schutzschicht aus an sich bekannten Materialien sachdienlich.

Die oberen und unteren Seiten der Umhüllung 8 mit der Seele 7 stehen inbezug zu den Profilteilen 5' leicht vor und sind freiliegend, so dass eine Abschirmung von durch den Spalt A zwischen den Bauteilen 1, 4 eintretenden Strahlungen und Frequenzwellen erfolgt.

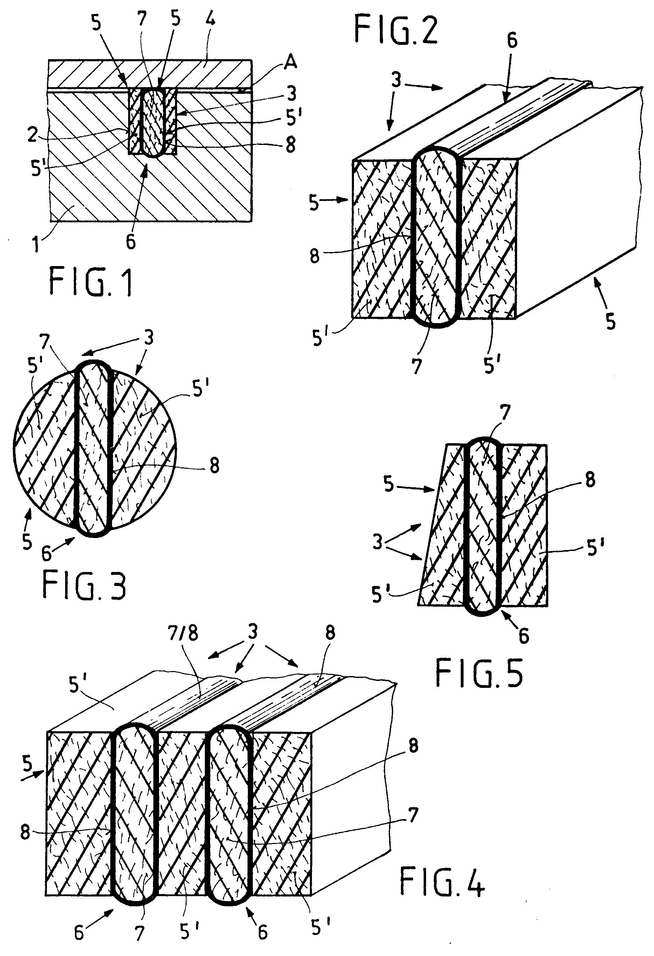

Beim zweiten Ausführungsbeispiel nach Fig. 3 ist der Abdichtungskörper 3 im Querschnitt kreisförmig. Die Profilteile 5' haben im Querschnitt die Gestalt von Kreisabschnitten, und deren Sehnen sind analog wie in den Fig. 1 und 2 mit der das Abschirmelement 6 bildenden Umhüllung 8 verklebt.

Fig. 4 zeigt einen Abdichtungskörper mit zwei im Abstand nebeneinander angeordneten Abschirmelementen 6, welche mit den zugehörigen drei Profilteilen 5' verbunden sind.

Fig. 5 zeigt einen Abdichtungskörper mit im Querschnitt gesehen pyramidenstumpfförmiger Gestaltung. Die mit Bezugszeichen belegten Bestandteile haben dabei den gleichen Sinn wie in den Fig. 1 und 2.

Der Abdichtungskörper 3 ist an geeigneten Stellen mit üblichen Selbstklebstoff, der nicht besonders gezeichnet ist, belegt.

Die stromleitende umhüllung 8 besteht zweckmässig aus Aluminium, Kupfer, Neusilber, stromleitender Legierung usw.

Die Herstellung ist einfach; um die vorgefertigte streifenförmige Seele 7 ist eine Folienbahn zu wickeln, deren Breite dem Umfang der Seele entspricht, alsdann ist durch Andrücken die Verklebung zu veranlassen. Die zum Anliegen kommenden Oberflächen von der Seele 7 und der Umhüllung 8 können vorgefertigt mit Trockenklebstoff ausgerüstet sein. Selbstredend ist auch das Aufspritzen von Klebstoff beim Herstellungsvorgang denkbar.

## Patentansprüche

1. Dichtung an gehäuseartigen Einrichtungen mit elektrischen Geräten mit einem Abdichtungskörper (3) und mindestens einem in letzterem befindlichen Abschirmelement (6), das durch eine stromleitende, foliendünne Umhüllung (8) gebildet ist, welche eine Seele (7) einschließt, und das zwischen zwei benachbarten Profilteilen (5') angebracht ist und mit diesen eine fugenlose Einheit bildet, dadurch gekennzeichnet, daß das Abschirmelement (6) beidseitig leicht über die Profilteile (5') vorsteht und daß das Elastizitätsmodul des Werkstoffes der Profilteile (5') einerseits und des Werkstoffes der Seele (7) andererseits so gewählt ist, daß der Werkstoff der Profilteile weichelastisch und der Werkstoff der Seele (7) zähelastisch ist.

2. Dichtung nach Anspruch 1, dadurch gekennzeichnet, daß die einander zugekehrten Oberflächen des Abdichtungskörpers (3) und der Umhüllung (8) durch kraftschlüssige Verbindung ein bandförmiges Profil (5) bilden.

3. Dichtung nach Anspruch 2, dadurch gekennzeichnet, daß die Seele (7) und die Umhüllung (8) miteinander verklebt sind.

4. Dichtung nach einem der Ansprüche 1 bis 3, dadurch gekennzeichnet, daß im Abstand nebeneinander zwei Abschirmelemente (6) im Abdichtungskörper (3) angeordnet sind.

5. Dichtung nach einem der Ansprüche 1 bis 4, dadurch gekennzeichnet, daß das Abschirmelement (6) zwischen zwei im Querschnitt halbkreisförmigen Profilteilen (5') eingebettet ist.

6. Dichtung nach einem der Ansprüche 1 bis 4, dadurch gekennzeichnet, daß die Profilteile (5') mit dem Abschirmelement (6) eine pyramidenstumpfförmige Einheit bilden.

## Claims

1. A seal on casing-like devices for electrical appliances, comprising a sealing member (3) containing at least one screening element (6) in the form of an electrically conductive thin film covering (8) enclosing a core (7) and disposed between two adjacent sectional parts (5') and forming a seamless unit therewith, characterized in that the screening element (6) projects on both sides slightly beyond the sectional parts (5') and the elasticity modulus of the material forming the sectional parts (5') on the one hand and the material forming the core (7) on the other hand are so chosen that the material of the sectional parts is flexible and the material of the core (7) is viscoplastic.

2. A seal according according to claim 1, characterized in that the facing surfaces of the sealing member (3) and the covering (8) are non-positively joined to form a section (5) in the form of a strip.

3. A seal according to claim 2, characterized in that the core (7) and the covering (8) are stuck together.

4. A seal according to any of claims 1 to 3, characterized in that two spaced-apart screening elements (6) are disposed in the sealing member (3).

5. A seal according to any of claims 1 to 4, characterised in that the screening element (6) is embedded between two sectional parts (5') having a semi-circular cross-section.

6. A seal according to any of claims 1 to 4, characterised in that the sectional parts (5') and the screening element (6) form a frusto-pyramidal unit.

## Revendications

1. Garniture sur des dispositifs en forme de carter avec des appareils électriques, avec un corps d'étanchéité (3) et un élément de blindage (6) au moins, situé dans ce dernier et formé par une gaine (8) conductrice de courant, de la minceur d'un film, qui renferme une âme (7), l'élément de blindage étant monté entre deux pièces profilées (5') adjacentes et formant avec ces dernières une unité continue, caractérisée en ce que l'élément de blindage (6) dépasse légèrement de part et d'autre des pièces profilées (5'), et en ce que le choix du module d'élasticité du matériau des pièces profilées (5'), d'une part, du matériau de l'âme (7), d'autre part, est tel que le matériau des pièces profilées est souple et élastique, et que le matériau de l'âme (7) est viscoplastique.

2. Garniture suivant la revendication 1, caractérisée en ce que les surfaces, tournées l'une vers l'autre, du corps d'étanchéité (3) et de la gaine (8) forment par adhérence un profil (5) en forme de bande.

3. Garniture suivant la revendication 2, caractérisée en ce que l'âme (7) et la gaine (8) sont collées entre elles.

4. Garniture suivant l'une quelconque des revendications 1 à 3, caractérisée en ce que deux éléments de blindage (6) sont juxtaposés à distance dans le corps d'étanchéité (3).

5. Garniture suivant l'une quelconque des revendications 1 à 4, caractérisée en ce que l'élément de blindage (6) est noyé entre deux pièces profilées (5') d'une section transversale en forme de demi-cercle.

6. Garniture suivant l'une quelconque des revendications 1 à 4, caractérisée en ce que les pièces profilées (5') forment une unité en forme de pyramide tronquée avec l'élément de blindage (6).
